(19) **Europäisches Patentamt / European Patent Office / Office européen des brevets**

(11) **EP 3 721 243 B1**

(12) **FASCICULE DE BREVET EUROPEEN**

(45) Date de publication et mention de la délivrance du brevet:
**16.07.2025 Bulletin 2025/29**

(21) Numéro de dépôt: **18815651.7**

(22) Date de dépôt: **06.12.2018**

(51) Classification Internationale des Brevets (IPC):
**G01R 31/367** (2019.01)    **G01R 31/392** (2019.01)

(52) Classification Coopérative des Brevets (CPC):
**G01R 31/392; G01R 31/367;** G01R 31/3833

(86) Numéro de dépôt international:
**PCT/EP2018/083767**

(87) Numéro de publication internationale:
**WO 2019/110720 (13.06.2019 Gazette 2019/24)**

(54) **PROCEDE DE DETERMINATION DE L'ETAT DE SANTE D'UNE BATTERIE ET DISPOSITIF METTANT EN OEUVRE LEDIT PROCEDE**

VERFAHREN ZUR BESTIMMUNG DES GESUNDHEITSZUSTANDES EINER BATTERIE UND VORRICHTUNG ZUR DURCHFÜHRUNG DES VERFAHRENS

METHOD FOR DETERMINING THE STATE OF HEALTH OF A BATTERY AND DEVICE FOR IMPLEMENTING THE METHOD

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **08.12.2017 FR 1761813**

(43) Date de publication de la demande:
**14.10.2020 Bulletin 2020/42**

(73) Titulaire: **Commissariat à l'Energie Atomique et aux Energies Alternatives**
**75015 Paris (FR)**

(72) Inventeurs:
• **DELAILLE, Arnaud**
**73000 Bassens (FR)**
• **MERGO MBEYA, Karrick**
**38000 Grenoble (FR)**

(74) Mandataire: **Cabinet Camus Lebkiri**
**25 rue de Maubeuge**
**75009 Paris (FR)**

(56) Documents cités:
EP-A1- 2 837 944      FR-A1- 3 051 981
US-A1- 2005 001 625

• **SARASKETA-ZABALA E ET AL: "Realistic lifetime prediction approach for Li-ion batteries", APPLIED ENERGY, ELSEVIER SCIENCE PUBLISHERS, GB, vol. 162, 11 November 2015 (2015-11-11), pages 839 - 852, XP029327368, ISSN: 0306-2619, DOI: 10.1016/ J.APENERGY.2015.10.115**
• **SARASKETA-ZABALA E ET AL: "Cycle ageing analysis of a LiFePO4/graphite cell with dynamic model validations: Towards realistic lifetime predictions", JOURNAL OF POWER SOURCES, ELSEVIER SA, CH, vol. 275, 29 October 2014 (2014-10-29), pages 573 - 587, XP029109266, ISSN: 0378-7753, DOI: 10.1016/ J.JPOWSOUR.2014.10.153**
• **SARASKETA-ZABALA E ET AL: "Calendar ageing analysis of a LiFePO4/graphite cell with dynamic model validations: Towards realistic lifetime predictions", JOURNAL OF POWER SOURCES, ELSEVIER SA, CH, vol. 272, 23 August 2014 (2014-08-23), pages 45 - 57, XP029048947, ISSN: 0378-7753, DOI: 10.1016/ J.JPOWSOUR.2014.08.051**

- MONIKA CHAWLA ET AL: "Utility energy storage life degradation estimation method", INNOVATIVE TECHNOLOGIES FOR AN EFFICIENT AND RELIABLE ELECTRICITY SUPPLY (CITRES), 2010 IEEE CONFERENCE ON, IEEE, PISCATAWAY, NJ, USA, 27 September 2010 (2010-09-27), pages 302 - 308, XP031788453, ISBN: 978-1-4244-6076-2

**Description**

**DOMAINE TECHNIQUE DE L'INVENTION**

Le domaine technique de l'invention est celui de la gestion des batteries. La présente invention concerne un procédé de détermination de l'état de santé d'une batterie et en particulier un procédé de détermination qui permet de déterminer ledit état de santé à partir d'une charge ou d'une décharge partielle de ladite batterie. L'invention concerne également un dispositif permettant de mettre en œuvre ladite méthode.

**ARRIERE-PLAN TECHNOLOGIQUE DE L'INVENTION**

De manière générale, l'état de santé d'une batterie n'est accessible qu'au moyen d'une charge ou d'une décharge complète de ladite batterie. Or, lorsqu'une batterie est installée dans un dispositif, il est rarement possible d'opérer une charge complète ou une décharge complète dans le cadre du fonctionnement normal dudit dispositif. De plus, cette opération de charge ou de décharge doit se faire dans des conditions maitrisées, notamment en ce qui concerne le courant, la température et les seuils de tension. Ainsi, le fonctionnement normal doit être altéré afin d'accéder audit état de santé. Afin de répondre à cette problématique, des méthodes alternatives ont été proposées afin de mesurer l'état de santé d'une batterie à partir de charges ou de décharges partielles.

Dans le brevet WO 2015049300 A1, les auteurs exploitent la phase de fin de charge à tension constante d'accumulateurs Li-Ion. Des paramètres de l'équation permettant de modéliser l'évolution du courant au cours de cette phase de charge présente une relation linéaire avec l'état de santé. L'exploitation de la fin de charge permet dans ce cas d'estimer l'état de santé. La méthode proposée présente cependant l'inconvénient d'exiger un contrôle strict du courant lors d'une première charge (ce dernier doit être constant) et de la tension lors d'une deuxième charge (cette dernière devant être égale à une valeur limite déterminée).

Dans le brevet WO2017/050944, l'inventeur exploite l'évolution de la tension à vide (sous courant nul) dite OCV pour Open Circuit Voltage, soit après une décharge, soit après une charge, en établissement une relation entre OCV et l'état de santé. Des charges ou décharges partielles sont ainsi exploitées pour estimer l'état de santé.

Dans le brevet WO2015/086753, les inventeurs exploitent une plage de tension de décharge, (respectivement de charge), restreinte par rapport à une pleine décharge (respectivement pleine charge). Les auteurs précisent la méthode de définition de cette plage restreinte, de manière à la rendre optimale et efficiente pour estimer l'état de santé à partir d'un cumul des Ah sur cette plage restreinte.

Le document FR3051981 A1 divulgue une méthode alternative de détermination d'état de santé d'une batterie lithium composée d'une ou plusieurs cellules reliées entre elles.

Il existe donc un besoin d'une méthode permettant de déterminer l'état de santé d'une batterie à partir d'une charge ou d'une décharge partielle sans pour autant exiger un contrôle strict du courant ou de la tension lors de ladite charge ou de ladite décharge.

**RESUME DE L'INVENTION**

L'invention offre une solution aux problèmes évoqués précédemment, en permettant de déterminer l'état de santé d'une batterie à partir d'une charge ou d'une décharge partielle de ladite batterie. L'invention est définie par les revendications indépendantes de procédé 1 et 3 ainsi que par le dispositif de la revendication indépendante 6, le programme d'ordinateur de la revendication 7 et le support lisible par ordinateur de la revendication 8. Des modes de réalisation optionnels sont définis par les revendications dépendantes 2, 4 et 5.

Un premier aspect de l'invention concerne un procédé de détermination de l'état de santé d'une batterie, dit état de santé global, la tension aux bornes de la batterie en fonction de l'état de charge pouvant être scindée en une première phase, dite phase A, et une deuxième phase, dite phase B, la phase A et la phase B étant distinctes et consécutives, la phase A étant associée à un premier état de santé et la phase B étant associée à un deuxième état de santé, l'état de santé global étant égal à la somme de l'état de santé associé à la phase A et l'état de santé associé à la phase B ; le procédé étant caractérisé en ce que l'état de santé global de la batterie est déterminé en fonction d'au moins une mesure de l'état de santé associé à la phase A et/ou de l'état de santé associé à la phase B.

Ainsi, il est possible de déterminer, à partir d'une charge (respectivement une décharge partielle) selon l'une des deux phases (phase A ou phase B) l'état de santé global d'une batterie. De plus aucune condition particulière sur le courant et la tension durant ladite charge (respectivement décharge) partielle n'est nécessaire pour mettre en œuvre le procédé selon un premier aspect de l'invention.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, l'état de santé (SOH$_Y$) associé à la phase Y avec Y = A ou B est mesuré à l'aide de l'équation suivante :

$$SOH_Y = 100 \times \frac{Q_{Dch\_}Y(k)}{Q_{Dch\_}Tot(0)}$$

où SOH$_Y$ est l'état de santé associé à la phase Y, Q$_{Dch\_}$Y(k) est la quantité d'Ah cumulés au cours d'une charge (respectivement décharge) lors de la phase Y au cycle k et Q$_{Dch\_}$Tot(0) est la quantité d'Ah cumulés au cours d'une charge (respectivement décharge) totale au premier cycle.

Autrement dit, l'état de santé associé à la phase A ou à la phase B peut être déterminé à partir de la quantité d'Ah cumulés lors d'une charge (respectivement d'une décharge) durant ladite phase, sans condition quant au régime de fonctionnement de la batterie. On entend par nombre de cycles équivalents le nombre égal à la quantité d'Ah cumulés en charge (respectivement en décharge) divisée par la capacité nominale de la batterie (ou encore capacité spécifiée par le fabricant de batterie).

Dans un mode de réalisation, le procédé de détermination selon l'invention comprend, lorsque la charge (respectivement décharge) partielle se produit dans la phase A :

- une étape de mesure de l'état de santé associé à la phase A ;
- si l'état de santé associé à la phase B est nul, une étape de détermination de l'état de santé global de la batterie, ledit état de santé global étant égal à l'état de santé associé la phase A déterminé lors de l'étape de mesure de l'état de santé associé la phase A ;
- si l'état de santé associé à la phase B est non nul, une étape de détermination de l'état de santé global de la batterie, ledit état de santé global étant égal à l'état de santé associé à la phase A déterminé lors de l'étape de mesure de l'état de santé associé la phase A additionné à l'état de santé associé à la phase B déterminé lors d'une mesure précédente.

Dans un mode de réalisation, le procédé de détermination selon l'invention comprend, lorsque la charge (respectivement décharge) partielle se produit dans la phase B :

- une étape de mesure de l'état de santé associé à la phase B ;
- si l'état de santé associé à la phase A est connu, une étape de détermination de l'état de santé global de la batterie, ledit état de santé global étant égal à l'état de santé associé à la phase A additionné à l'état de santé associé à la phase B déterminé à l'étape de mesure de l'état de santé associé à la phase B ;
- si l'état de santé associé à la phase A n'est pas connu, une étape de détermination de l'état de santé global de la batterie, ledit état de santé global étant égal à l'état de santé associé à la phase B mesuré à l'étape de mesure de l'état de santé associé à la phase B additionné à l'état de santé associé à la phase A initial.

Ainsi, il est possible de déterminer l'état de santé global de la batterie à partir de la mesure de l'état de santé associé à la phase A ou à la phase B, c'est-à-dire à partir d'une décharge partielle effectuée dans la phase A ou dans la phase B.

Selon la revendication indépendante 3, l'état de santé associé à la phase Y avec Y = A ou B peut être modélisé par l'équation suivant :

$$SOH_Y = \max(A_Y x + B_Y, 0)$$

où A$_X$ et B$_X$ sont des constantes et x est un nombre de cycles équivalents et le procédé selon un premier aspect de l'invention comprend :

- une première phase, dite phase d'initialisation et comprenant :

  ▪ une étape d'au moins quatre mesures de l'état de santé global, chaque mesure étant effectuée sur une charge (respectivement une décharge) complète ;
  ▪ une étape de détermination des paramètres des modèles associés à l'état de santé associé à la phase A et à la phase B ;

- une deuxième phase, dite phase de mesure et comprenant :

  ▪ une étape de détermination du nombre de cycles équivalents à l'aide d'une charge (respectivement décharge) partielle dans la phase A ou la phase B ;
- une étape de détermination de l'état de santé global ;

l'état de santé global étant obtenu par addition de l'état de santé associé à la phase A et de l'état de santé associé à la phase B, l'état de santé associé à chacune des phases A et B étant déterminé à partir du modèle obtenu lors de la phase d'initialisation et du nombre de cycles équivalents obtenu lors de la phase de mesure.

Ainsi, il est permis de déterminer les paramètres de l'équation régissant l'évolution de l'état de santé associé à la phase A et l'état de santé associé à la phase B (et donc l'état de santé global) en fonction du nombre de cycles équivalents. Cela signifie également qu'il est possible de connaitre le nombre de cycles équivalents à partir duquel l'état de santé associé à la phase B est nul.

Un deuxième aspect de l'invention concerne un dispositif de détermination de l'état de santé d'une batterie comprenant un moyen de mesure du courant entrant et sortant de la batterie ainsi qu'un moyen de calcul connecté audit moyen de mesure et configuré pour mettre en œuvre un procédé selon un premier aspect de l'invention.

Le dispositif selon l'invention permet de déterminer l'état de santé global de la batterie à partir d'une charge ou d'une décharge partielle sans pour autant exiger un contrôle strict du courant ou de la tension lors de ladite charge ou de ladite décharge.

Un troisième aspect de l'invention concerne un programme d'ordinateur comprenant des instructions qui conduisent le dispositif selon un deuxième aspect de l'invention à exécuter les étapes du procédé selon un premier aspect de l'invention.

Un quatrième aspect de l'invention concerne un support lisible par ordinateur, sur lequel est enregistré le programme d'ordinateur selon un troisième aspect de l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre deux courbes illustrant les deux phases dans la charge et la décharge d'une batterie.
- La figure 2 montre les deux périodes dans l'évolution de l'état de santé global d'une batterie.
- La figure 3 montre une régression linéaire permettant de déterminer les paramètres de l'état de santé global d'une batterie.
- La figure 4 montre un logigramme d'un mode de réalisation d'un procédé selon un premier aspect de l'invention.
- La figure 5 montre un logigramme d'un mode de réalisation d'un procédé selon un premier aspect de l'invention.

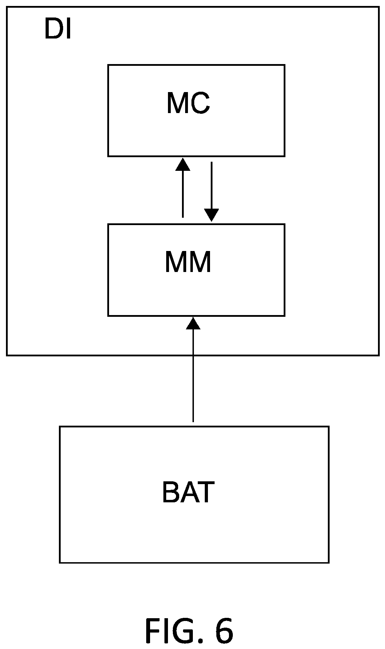

- La figure 6 montre une représentation schématique d'un dispositif selon un deuxième aspect de l'invention.

Sauf précision contraire, un même élément apparaissant sur des figures différentes présente une référence unique.

Un premier aspect de l'invention concerne un procédé 10 de détermination de l'état de santé $SOH_{Tot}$ d'une batterie. Afin de pouvoir mettre en œuvre le procédé 10 selon l'invention, il importe que l'état de santé $SOH_{Tot}$ de la batterie, dit état de santé global, puisse être scindé en un premier état de santé $SOH_A$ associé à une première phase de charge ou décharge de la batterie, dite phase A, et à un deuxième état de santé $SOH_B$ associé à une deuxième phase de charge ou décharge de la batterie, dite phase B. Autrement dit, la caractéristique de la tension aux bornes de la batterie en fonction de l'état de charge peut être scindée en une première phase, dite phase A, et une deuxième phase, dite phase B, la phase A et la phase B étant distinctes et consécutives, la phase A étant associée à un premier état de santé $SOH_A$ et la phase B étant associée à un deuxième état de santé $SOH_B$. Ces deux phases correspondent donc à des charges (ou des décharges) partielles consécutives de sorte à former une charge (ou une décharge) complète. Ainsi, cette caractéristique peut notamment être vérifiée en mesurant la tension aux bornes d'une batterie en fonction de l'état de charge SOC de cette dernière. Plus particulièrement, la limite entre la phase A et la phase B peut être déterminée en identifiant une pente seuil (différence de tension entre deux valeurs de SOC divisée par la différence entre les deux valeurs de SOC) supérieure à une valeur seuil, par exemple supérieure à 50mV/%SOC, sachant que de manière générale les pentes sont inférieures à 20mV/%SOC pour la majorité des valeurs de %SOC (à l'exception de la toute fin de décharge). Le procédé selon un premier aspect de l'invention est particulièrement avantageux dans le cas de batteries Na-Ion. En effet, une batterie Na-Ion présente ces deux phases A et B. Cependant, le procédé peut également être utilisé pour d'autres types de batterie, par exemple des batteries $Na-NiCl_2$ (batteries hautes températures) et des batteries Li-Ion avec des matériaux d'électrode mixtes.

En effet, les inventeurs ont mis en évidence que l'évolution de l'état de santé $SOH_{Tot}$ global pouvait être décomposée en deux contributions :

- une première contribution dû à l'évolution de l'état de santé $SOH_{Tot}$ lors des charges et décharges de la batterie dans une première phase, dite phase A dans la suite, cette contribution étant nommée état de santé $SOH_A$ associé à la phase A ;
- une deuxième contribution dû à l'évolution de l'état de santé $SOH_{Tot}$ lors des charges et décharges de la batterie dans une deuxième phase, dite phase B dans la suite, cette contribution étant nommée état de santé $SOH_B$ associé à la phase B.

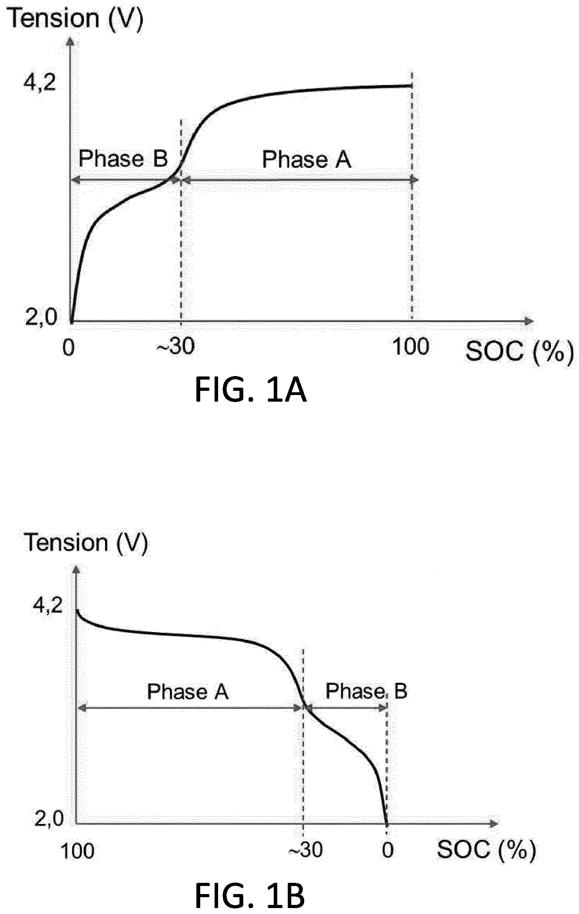

La figure 1 illustre la charge (figure 1A) et la décharge (figure 1B) d'une batterie. Plus particulièrement les deux courbes représentent la tension aux bornes d'une batterie en fonction de l'état de charge SOC dans le cas d'une batterie Na-Ion et en particulier d'une batterie Na-Ion organique. Sur ces deux courbes, deux phases peuvent être facilement délimitées, le point de délimitation étant le point d'inflexion de la courbe qui se produit de manière générale quand l'état de charge SOC est environ égal à 30% de l'état de charge SOC en pleine charge. La phase A au sens de l'invention est la phase durant laquelle l'état de charge SOC se situe entre l'état de charge maximum et l'état de charge de transition, c'est-à-dire l'état de charge pour lequel se produit l'inflexion de la courbe évoquée précédemment. La phase B de l'invention concerne quant à elle la phase durant laquelle l'état de charge se situe entre l'état de charge de transition et l'état de charge minimum.

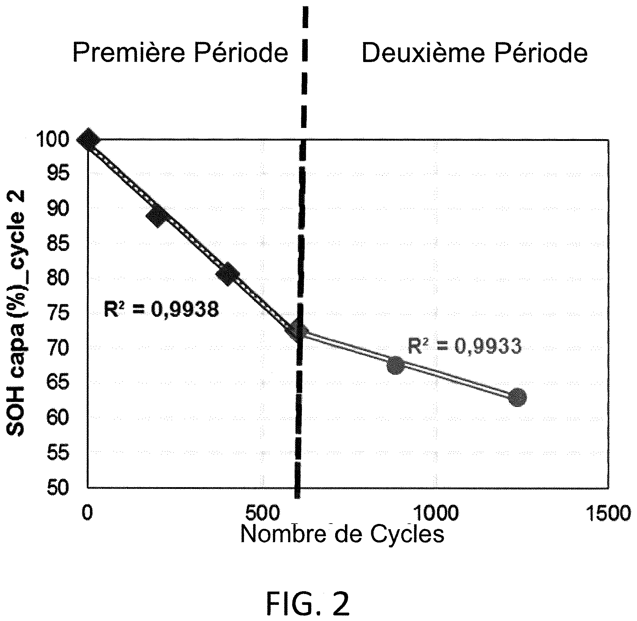

En associant un état de santé $SOH_A$ à la phase A et un état de santé $SOH_B$ à la phase B, les inventeurs ont pu mettre en évidence deux périodes dans l'évolution de l'état de santé $SOH_{Tot}$ global de la batterie. Ces deux périodes sont clairement visibles sur la figure 2 qui représente l'état de santé $SOH_{Tot}$ global d'une batterie en fonction d'un nombre de cycles équivalents. Pour rappel, On entend par nombre de cycles équivalents le nombre égal à la quantité d'Ah cumulés en charge (ou en décharge) divisée par la capacité nominale de la batterie (ou encore capacité spécifiée par le fabricant de batterie). Durant la première période, les inventeurs ont démontré que l'état de santé $SOH_{Tot}$ global de la batterie avait deux composantes : une première composante due à l'état de santé $SOH_A$ associé à la phase A et une deuxième due à l'état de santé $SOH_B$ associé à la phase B. De plus, durant cette première période, ils ont constaté que la variation de l'état de santé $SOH_{Tot}$ global était principalement dû à la variation de l'état de santé $SOH_B$ associé à la phase B de sorte que, dans une première approximation, l'état de santé $SOH_{Tot}$ global pouvait être déduit de l'état de santé $SHO_A$ associé à la phase A déterminé lors d'une mesure précédente, par exemple l'état de santé $(SOH_A)$ associé à la phase A initial (qui peut être donné par le fabricant ou déterminé lors de la mise en place de la batterie), additionné à l'état de santé $SOH_B$ associé à la phase B. Durant la deuxième période, l'état de santé $SOH_B$ associé à la phase B devient nul et l'état de santé $SOH_{Tot}$ global se confond alors avec l'état de santé $SOH_A$ associé à la phase A. Autrement dit, sachant que l'état de santé $SOH_{Tot}$ global se présente comme la somme de l'état de santé $SOH_A$ associé à la phase A et l'état de santé $SOH_B$ associé à la phase B, il devient donc possible, une fois une telle décomposition mise en évidence, de déterminer l'état de santé $SOH_{Tot}$ global de la batterie en fonction d'au moins une mesure de l'état de santé $SOH_A$ associé à la phase A et/ou l'état de santé $SOH_B$ associé à la phase B, ladite mesure étant par exemple réalisée à l'aide d'une décharge partielle sur la phase A et/ou la phase B.

Dans la suite, plusieurs modes de réalisation de ce procédé seront présentés afin d'illustrer comment il est possible de mettre à profit les constations des inventeurs afin de déterminer l'état de santé $SOH_{Tot}$ global d'une batterie à partie d'une charge ou d'une décharge partielle se produisant dans la phase A ou dans la phase B. On entend par « une charge (respectivement un décharge) se produisant durant la phase Y » le fait que durant ladite charge (respectivement ladite décharge), l'état de charge SOC de la batterie passe par l'ensemble des valeurs situées entre les deux bornes de la phase considérée. Par exemple, si une charge se produit durant la phase A, alors l'état de charge durant ladite charge va, à minima, varier de l'état de charge de transition (tel que défini plus haut) à l'état de charge maximal. Bien sûr, l'état de charge de départ de ladite charge peut être inférieur à l'état de charge de transition mais, pour que la charge soit considérée comme étant effectuée durant la phase A, il ne peut pas être supérieur à ce dernier.

Dans un mode de réalisation, l'état de santé $SOH_Y$ associé à la phase Y avec Y = A ou B est mesuré à l'aide de l'équation suivante :

$$SOH_Y = 100 \times \frac{Q_{Dch\_}Y(k)}{Q_{Dch\_}Tot(0)}$$

où $SOH_Y$ est l'état de santé associé à la phase Y, $Q_{Dch\_}Y(k)$ est la quantité d'Ah cumulés ou de Wh cumulés au cours d'une charge (respectivement décharge) lors de la phase Y au cycle k de charge (respectivement décharge) et $Q_{Dch\_}Tot(0)$ est la quantité d'Ah cumulés ou de Wh cumulés au cours d'une charge (respectivement décharge) totale au premier cycle. Autrement dit, en mesurant la quantité cumulée d'Ah ou de Wh au cours d'une charge à un cycle k, par exemple une charge durant la phase A, et connaissant la quantité d'Ah cumulée ou de Wh cumulés au cours d'une charge totale au premier cycle, il est possible de déterminer l'état de santé $SOH_A$ associé à la phase A. Il en est bien sûr de même pour l'état de santé $SOH_B$ associé à la phase B. La quantité d'Ah cumulés ou de Wh cumulés au cours d'une charge totale au premier cycle peut par exemple être fournie par le constructeur au même titre que les autres caractéristiques techniques de la batterie. De manière alternative ou complémentaire, cette mesure peut être effectuée lorsqu'une batterie est mise en place dans un dispositif, par exemple dans un véhicule électrique.

Comme expliqué précédemment, grâce au procédé selon l'invention, il est possible de déterminer l'état de santé $SOH_{Tot}$ global d'une batterie à partir d'une charge partielle (respectivement décharge partielle) pourvu que ladite charge (respectivement ladite décharge) se fasse durant la phase A ou la phase B. En fonction de la phase durant laquelle se fait la charge (respectivement la décharge), les étapes à réaliser afin de déterminer l'état de santé $SOH_{Tot}$ global de la batterie peuvent différer.

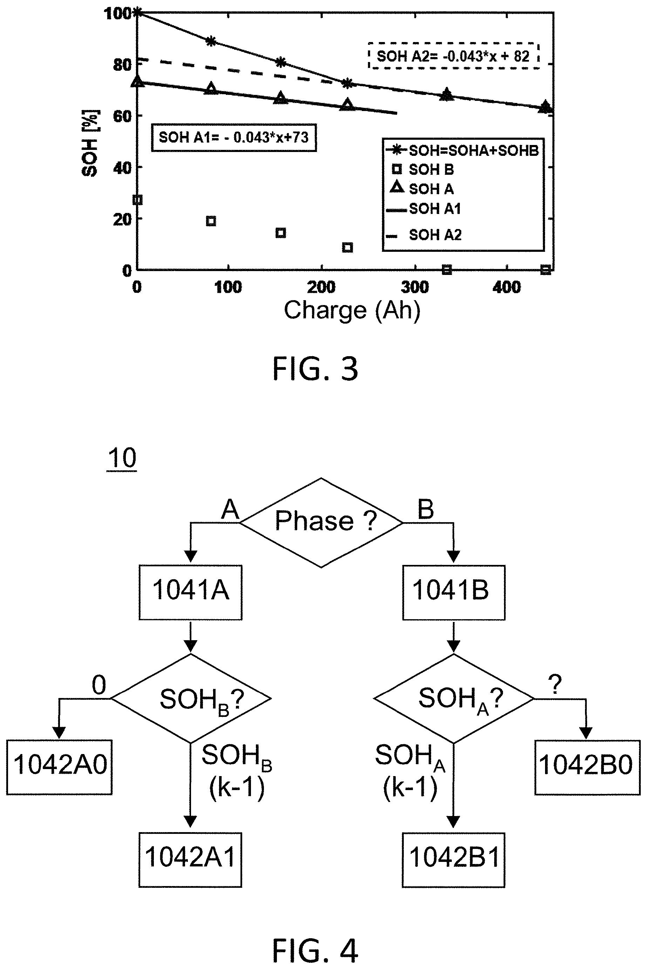

Dans un mode de réalisation illustré à la figure 4, lorsque la charge (respectivement, la décharge) partielle se produit dans la phase A, le procédé 10 selon l'invention comprend une étape 1041A de mesure de l'état de santé $SOH_A$ associé à la phase A. Comme détaillé précédemment, cette mesure peut être effectuée par la mesure de la quantité d'Ah cumulés au cours de la charge (respectivement la décharge) à un cycle k considéré. Le procédé comprend également si l'état de santé $SOH_B$ associé à la phase B est nul, une étape 1042A0 de détermination de l'état de santé $SOH_{Tot}$ global de la batterie, ledit état de santé $SOH_{Tot}$ global étant égal à l'état de santé $SOH_A$ associé à la phase A déterminé à l'étape 1041A de mesure de l'état de santé $SOH_A$ associé à la phase A. En effet, comme détaillé précédemment, lorsque l'état de santé $SOH_B$ associé à la phase B devient nul et l'état de santé $SOH_{Tot}$ global se confond alors avec l'état de santé $SOH_A$ associé à la phase A. De la même manière, lorsque l'état de santé $SOH_B$ associé à la phase B est non nul, le procédé comprend une étape 1042A1 de détermination de l'état de santé $SOH_{Tot}$ global de la batterie, ledit état de santé $SOH_{Tot}$ global étant égal à l'état de santé $SOH_A$ associé à la phase A déterminé à l'étape 1041A de mesure de l'état de santé $SOH_A$ associé à la phase A additionné à l'état de santé $SOH_B$ associé à la phase B déterminé lors d'une mesure précédente. En effet, la valeur de l'état de santé $SOH_B$ associé à la phase B peut être connue d'une mesure précédente. La mesure précédente pourra par exemple être effectuée lors d'une décharge résiduelle (c'est-à-dire une décharge visant à vider la batterie complètement à partir d'un faible état de charge), une telle mesure présentant l'avantage de pouvoir être rapidement effectuée. De plus, lorsque la valeur de l'état de santé $SOH_B$ associé à la phase B est mesurée comme étant égale à zéro lors d'une mesure précédente, un booléen peut être basculé à une valeur « vrai » de sorte que pour les exécutions suivantes du procédé 10 selon l'invention, cette information puisse être prise en compte.

Dans un mode de réalisation illustré à la figure 4, lorsque la charge (respectivement décharge) partielle se produit dans la phase B, le procédé 10 selon l'invention comprend une étape 1041B de mesure de l'état de santé $SOH_B$ associé à la phase B. Comme détaillé précédemment, cette mesure peut être effectuée par la mesure de la quantité d'Ah cumulés au cours de la charge (respectivement la décharge) à un cycle k considéré. Le procédé 10 comprend également, si l'état de santé $SOH_A$ associé à la phase A est connu, une étape 1042B1 de détermination de l'état de santé $SOH_{Tot}$ global de la batterie, ledit état de santé global $SOH_{Tot}$ étant égal à l'état de santé $SOH_A$ associé à la phase A additionné à l'état de santé $SOH_B$ associé à la phase B déterminé à l'étape 1041B de mesure de l'état de santé $SOH_B$ associé à la phase B. La valeur de l'état de santé $SOH_A$ associé à la phase A peut être connue d'une mesure précédente. De la même manière, le procédé 10 comprend, lorsque l'état de santé $SOH_A$ associé à la phase A n'est pas connu, une étape 11042B0 de détermination de l'état de santé $SOH_{Tot}$ global de la batterie, ledit état de santé $SOH_{Tot}$ global étant égal à l'état de santé $SOH_B$ associé à la phase B déterminé à l'étape 1041B de mesure de l'état de santé $SOH_B$ associé à la phase B additionné à l'état de santé $SOH_A$ associé à la phase A initial (c'est-à-dire l'état de santé $SOH_A$ associé la phase A au moment de la mise en place de ladite batterie, ce dernier pouvant par exemple être communiqué par le constructeur ou mesuré lors de la mise en place de la batterie). Autrement dit, l'état de santé global $SOH_{Tot}$ peut être calculé à l'aide de la formule suivante :

$$SOH_{Tot}(t) = SOH_A(t_0) + SOH_B(t)$$

Dans un mode de réalisation, l'état de santé $SOH_Y$ associé à la phase Y peut être modélisé par l'équation suivant :

$$SOH_Y = \max(A_Y x + B_Y, 0)$$

où $A_Y$ et $B_Y$ sont des constantes et x est un nombre de cycles équivalents. Autrement dit, l'état de santé globale $SOH_{Tot}$ peut être exprimé à l'aide de la formule suivant :

$$SOH_{Tot} = SOH_A + SOH_B = \max(A_A x + B_A, 0) + \max(A_B x + B_B, 0)$$

L'état de santé $SOH_{Tot}$ global durant la première période peut donc être formulé comme suit :

$$SOH_{Tot} = (A_A + A_B)x + B_A + B_B$$

Comme cela a été décrit précédemment, durant la seconde période, l'état de santé $SOH_B$ associé à la phase B est nul. L'état de santé $SOH_{Tot}$ global durant la deuxième période peut donc être formulé comme suit :

$$SOH_{Tot} = A_A x + B_A$$

Autrement dit, lorsque les paramètres $\{A_A, A_B, B_A, B_B\}$ ont été déterminés, il est possible de déterminer l'état de santé $SOH_{Tot}$ global en ayant connaissance du nombre x de cycles équivalents.

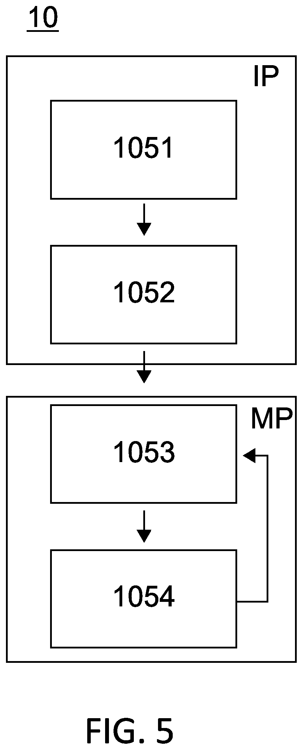

Dans un mode de réalisation illustré à la figure 5, afin de déterminer ces paramètres, le procédé 10 comprend une première phase IP, dite phase d'initialisation et comprenant au moins une étape 1051 de quatre mesures de l'état de santé $SOH_{Tot}$ global, chaque mesure étant effectuée sur une charge (respectivement une décharge) complète ; et une étape 1052 de détermination des paramètres $\{A_A, A_B, B_A, B_B\}$ des modèles associés à l'état de santé $SOH_A$ associé à la phase A et l'état de santé $SOH_B$ associé à la phase B. En effet, en effectuant au moins quatre mesures pour quatre états de santé $SOH_{Tot}$ global différent, il est possible, par exemple à l'aide d'une méthode des moindres carrés, de déterminer les paramètres $\{A_A, A_B, B_A, B_B\}$ comme illustré à la figure 3. De préférence, lors de la phase IP d'initialisation, chaque mesure de l'état de santé $SOH_{Tot}$ global est effectuée de sorte que la variation de l'état de santé $SOH_{Tot}$ global entre ladite mesure et la mesure précédente est supérieure à 2% de la valeur mesurée. Cela permet d'obtenir une précision plus importante dans la détermination des paramètres $\{A_A, A_B, B_A, B_B\}$.

Le procédé 10 comprend également une deuxième phase MP, dite phase de mesure. Cette phase MP de mesure comprend une étape 1053 de détermination du nombre de cycles équivalents à l'aide d'une charge (respectivement décharge) partielle dans la phase A ou la phase B.

Lorsque la charge (respectivement décharge) lors de la phase MP de mesure se produit durant la phase A, le nombre x de cycles équivalents est déterminé à l'aide de la formule suivante :

$$x = \frac{SOH_A - B_A}{A_A}$$

De la même manière, lorsque la charge (respectivement décharge) lors de la phase de mesure MP se produit durant la phase B, le nombre x de cycles équivalents est déterminé à l'aide de la formule suivante :

$$x = \frac{SOH_B - B_B}{A_B}$$

Une fois le nombre de cycles équivalents déterminé, la phase MP de mesure comprend une étape 1054 de détermination de l'état de santé $SOH_{Tot}$ global. Cette détermination s'effectue à l'aide de la formule suivante (déjà présentée auparavant) :

$$SOH_{Tot} = SOH_A + SOH_B = \max(A_A x_d + B_A, 0) + \max(A_B x_d + B_B, 0)$$

où $x_d$ est le nombre de cycles équivalents déterminé lors de étape 1053 de détermination du nombre de cycles.

Afin de mettre en œuvre un procédé selon un premier aspect de l'invention, un deuxième aspect de l'invention concerne un dispositif DI de détermination de l'état de santé $SOH_{Tot}$ d'une batterie BAT comprenant un moyen de mesure MM du courant entrant et sortant de la batterie BAT ainsi qu'un moyen de calcul MC connecté audit moyen de mesure MM. De plus, le moyen de calcul MC est configuré pour mettre en œuvre un procédé 10 selon un premier aspect de l'invention. Le moyen de calcul MC peut prendre la forme d'un processeur associé à une mémoire (par exemple une mémoire RAM), d'un FPGA ou bien encore d'une carte ASIC. La communication entre le moyen de calcul MC et le moyen de mesure MM peut s'effectuer par l'intermédiaire d'un bus ou bien encore au moyen d'un réseau filaire (par exemple Ethernet®) ou bien en sans-fil (par exemple, WiFi® ou Bluetooth®). Le moyen de calcul MC peut ainsi déclencher une mesure, ladite mesure étant effectuée par le moyen de mesure MM, mais également réceptionner les données issues de la mesure. Ainsi, le moyen de calcul MC est configuré pour mettre en œuvre, à l'aide du moyen de mesure MM, un procédé 10 de détermination de l'état de santé $SOH_{Tot}$ d'une batterie BAT selon un premier aspect de l'invention, les instructions nécessaires à cette mise en œuvre étant par exemple stockées sur une mémoire (par exemple un disque dur ou une mémoire flash connectés au moyen de calcul MC) et chargées par le moyen de calcul MC en vue de leur exécution.

**Revendications**

1.  Procédé (10) de détermination de l'état de santé (SOH) d'une batterie dit état de santé global, la tension aux bornes de la batterie en fonction de l'état de charge pouvant être scindée en une première phase, dite phase A, et une deuxième phase, dite phase B, la phase A et la phase B étant distinctes et consécutives, la phase A étant associée à un premier état de santé ($SOH_A$) et la phase B étant associée à un deuxième état de santé ($SOH_B$), l'état de santé ($SOH_{Tot}$) global étant égal à la somme de l'état de santé ($SOH_A$) associé à la phase A et l'état de santé ($SOH_B$) associé à la phase B, l'évolution de l'état de santé ($SOH_{Tot}$) global pouvant être divisée en deux périodes consécutives, une première période durant laquelle la variation de l'état de santé ($SOH_{Tot}$) global est principalement due à la variation de l'état de santé ($SOH_B$) associé à la phase B et une deuxième période durant laquelle l'état de santé ($SOH_B$) associé à la phase B devient nul et l'état de santé ($SOH_{Tot}$) global se confond alors avec l'état de santé ($SOH_A$) associé à la phase A ; le procédé étant **caractérisé en ce qu'**il comprend :

    - lorsque la charge, respectivement décharge, se produit dans la phase A :

        ▪ une étape (1041A) de mesure de l'état de santé ($SOH_A$) associé à la phase A ;
        ▪ si l'état de santé ($SOH_B$) associée à la phase B est nul, une étape (1042A0) de détermination de l'état de santé ($SOH_{Tot}$) global de la batterie, ledit état de santé ($SOH_{Tot}$) global étant égal à l'état de santé ($SOH_A$) associé à la phase A déterminé à l'étape (1041A) de mesure de l'état de santé ($SOH_A$) associé à la phase A.
        ▪ si l'état de santé ($SOH_B$) associé à la phase B est non nul, une étape (1042A1) de détermination de l'état de santé ($SOH_{Tot}$) global de la batterie, ledit état de santé ($SOH_{Tot}$) global étant égal à l'état de santé ($SOH_A$) associé à la phase A déterminé lors de l'étape (1041A) de mesure de l'état de santé ($SOH_A$) associé à la phase A additionné à l'état de santé ($SOH_B$) associé à la phase B déterminé lors d'une mesure précédente ;

    - et/ou, lorsque la charge, respectivement, la décharge, se produit dans la phase B :

        ▪ une étape (1041B) de mesure de l'état de santé ($SOH_B$) associé à la phase B ;
        ▪ si l'état de santé ($SOH_A$) associé à la phase A est connu, une étape (1042B1) de détermination de l'état de santé ($SOH_{Tot}$) global de la batterie, ledit état de santé ($SOH_{Tot}$) global étant égal à l'état de santé ($SOH_A$) associé à la phase A additionné à l'état de santé ($SOH_B$) associé à la phase B mesuré à l'étape (1041B) de mesure de l'état de santé ($SOH_B$) associé à la phase B ;
        ▪ si l'état de santé ($SOH_A$) associé à la phase A n'est pas connu, une étape (1042B0) de détermination de l'état de santé ($SOH_{Tot}$) global de la batterie, ledit état de santé ($SOH_{Tot}$) global étant égal à l'état de santé ($SOH_B$) associé à la phase B mesuré à l'étape (1041B) de mesure de l'état de santé ($SOH_B$) associé à la phase B additionné à l'état de santé ($SOH_A$) associé à la phase A initial..

2.  Procédé de détermination selon la revendication précédente **caractérisé en ce que** l'état de santé ($SOH_Y$) associé à la phase Y avec Y = A ou B est mesuré à l'aide de l'équation suivante :

$$SOH_Y = 100 \times \frac{Q_{Dch\_}Y(k)}{Q_{Dch\_}Tot(0)}$$

où $SOH_Y$ est l'état de santé associé à la phase Y, $Q_{Dch\_}Y(k)$ est la quantité d'Ah ou de Wh cumulés au cours d'une charge, respectivement décharge, lors de la phase Y au cycle k et $Q_{Dch\_}Tot(0)$ est la quantité d'Ah ou de Wh cumulés au cours d'une charge, respectivement d'une décharge, totale au premier cycle.

3.  Procédé (10) de détermination de l'état de santé (SOH) d'une batterie dit état de santé global, la tension aux bornes de la batterie en fonction de l'état de charge pouvant être scindée en une première phase, dite phase A, et une deuxième phase, dite phase B, la phase A et la phase B étant distinctes et consécutives, la phase A étant associée à un premier état de santé ($SOH_A$) et la phase B étant associée à un deuxième état de santé ($SOH_B$), l'état de santé ($SOH_{Tot}$) global étant égal à la somme de l'état de santé ($SOH_A$) associé à la phase A et l'état de santé ($SOH_B$) associé à la phase B, l'évolution de l'état de santé ($SOH_{Tot}$) global pouvant être divisée en deux périodes consécutives, une première période durant laquelle la variation de

    l'état de santé ($SOH_{Tot}$) global est principalement due à la variation de l'état de santé ($SOH_B$) associé à la phase B et une deuxième période durant laquelle l'état de santé ($SOH_B$) associé à la phase B devient nul et l'état de santé ($SOH_{Tot}$) global se confond alors avec l'état de santé ($SOH_A$) associé à la phase A, procédé dans lequel l'état de santé ($SOH_Y$) associé à la phase Y avec Y = A ou B peut être modélisé par l'équation suivant :

$$SOH_Y = \max(A_Y x + B_Y, 0)$$

où $A_X$ et $B_X$ sont des constantes et x est un nombre de cycles équivalents ; le procédé étant **caractérisé en ce qu'**il comprend :

- une première phase (IP), dite phase d'initialisation et comprenant :

- une étape (1051) d'au moins quatre mesures de l'état de santé ($SOH_{Tot}$) global, chaque mesure étant effectuée sur une charge, respectivement une décharge complète ;
- une étape (1052) de détermination des paramètres des modèles associés à l'état de santé ($SOH_A$, $SOH_B$) associé à la phase A et à la phase B ;
- une deuxième phase (MP), dite phase de mesure et comprenant :
- une étape (1053) de détermination du nombre de cycles équivalents à l'aide d'une charge, respectivement une décharge, partielle dans la phase A ou la phase B ;
- une étape (1054) de détermination de l'état de santé global ($SOH_{Tot}$) ;

l'état de santé global ($SOH_{Tot}$) étant déterminé à partir du modèle obtenu lors de la phase d'initialisation (IP) et du nombre de cycles équivalents obtenu lors de la phase de mesure (MP).

4. Procédé de détermination selon la revendication précédente **caractérisé en ce que**, lors de la phase d'initialisation (IP), chaque mesure de l'état de santé global ($SOH_{Tot}$) est effectuée de sorte que la variation de l'état de santé global entre ladite mesure et la mesure précédente est supérieure ou égale à 2% à la valeur de ladite mesure.

5. Procédé selon l'une des deux revendications précédentes **caractérisé en ce que**, lorsque la charge (respectivement, la décharge) lors de l'étape (1053) de détermination du nombre de cycles équivalents se produit durant la phase Y avec Y = A ou B, le nombre de cycles équivalents est déterminé à l'aide de la formule suivante :

$$x = \frac{SOH_Y - B_Y}{A_Y}$$

6. Dispositif (DI) de détermination de l'état de santé d'une batterie comprenant un moyen de mesure (MM) du courant entrant et sortant de la batterie ainsi qu'un moyen de calcul (MC) connecté audit moyen de mesure (MM) et configuré pour mettre en œuvre un procédé (10) selon l'une quelconque des revendications 1 à 5.

7. Programme d'ordinateur comprenant des instructions qui conduisent le dispositif (DI) selon la revendication 6 à exécuter les étapes du procédé (10) selon l'une quelconque des revendications 1 à 5.

8. Support lisible par ordinateur, sur lequel est enregistré le programme d'ordinateur selon la revendication 7.

**Patentansprüche**

1. Verfahren (10) zur Bestimmung des Gesundheitszustands (SOH) einer Batterie, der als ganzheitlicher Gesundheitszustand bezeichnet wird, wobei die Spannung an den Anschlüssen der Batterie in Abhängigkeit vom Ladezustand in eine erste Phase, Phase A genannt, und eine zweite Phase, Phase B genannt, unterteilt werden kann, wobei die Phase A und die Phase B unterschiedlich und aufeinanderfolgend sind, die Phase A mit einem ersten Gesundheitszustand ($SOH_A$) und die Phase B mit einem zweiten Gesundheitszustand ($SOH_B$) verbunden ist, wobei der ganzheitliche Gesundheitszustand ($SOH_{Tot}$) gleich der Summe des mit der Phase A verbundenen Gesundheitszustands ($SOH_A$) und des mit der Phase B verbundenen Gesundheitszustands ($SOH_B$) ist und die Veränderung des ganzheitlichen Gesundheitszustands ($SOH_{Tot}$) in zwei aufeinanderfolgende Perioden unterteilt werden kann, einer ersten Periode, in der die Veränderung des ganzheitlichen Gesundheitszustands ($SOH_{Tot}$) hauptsächlich auf die Veränderung des mit Phase B assoziierten Gesundheitszustands ($SOH_B$) zurückzuführen ist, und einer zweiten Periode, in der der mit Phase B assoziierte Gesundheitszustand ($SOH_B$) null wird und der ganzheitliche Gesundheitszustand (SOH$_{Tot}$) dann mit dem mit Phase A assoziierten Gesundheitszustand (SOH$_A$) ineinander übergeht; wobei das Verfahren **dadurch gekennzeichnet ist, dass** es umfasst:

- wenn die Ladung bzw. Entladung in der Phase A stattfindet:

  ▪ einen Schritt (1041A) des Messens des Gesundheitszustands (SOH$_A$), der der Phase A zugeordnet ist;
  ▪ wenn der der Phase B zugeordnete Gesundheitszustand (SOHs) null ist, einen Schritt (1042A0) zum Bestimmen des ganzheitlichen Gesundheitszustands (SOH$_{Tot}$) der Batterie, wobei der ganzheitliche Gesundheitszustand (SOH$_{Tot}$) gleich dem der Phase A zugeordneten Gesundheitszustand (SOH$_A$) ist, der im Schritt (1041A) zum Messen des der Phase A zugeordneten Gesundheitszustands (SOH$_A$) bestimmt wird.
  ▪ wenn der der Phase B zugeordnete Gesundheitszustand (SOH$_B$) ungleich null ist, einen Schritt (1042A1) zur Bestimmung des ganzheitlichen Gesundheitszustands (SOH$_{Tot}$) der Batterie, wobei der ganzheitliche Gesundheitszustand (SOH$_{Tot}$) gleich dem Gesundheitszustand (SOH$_A$) ist, der der Phase A zugeordnet ist, die im Schritt (1041A) des Messens des Gesundheitszustands (SOH$_A$), der der Phase A zugeordnet ist, bestimmt wurde, zuzüglich des Gesundheitszustands (SOH$_B$), der der Phase B zugeordnet ist, der in einer vorhergehenden Messung bestimmt wurde;

- und/oder, wenn die Ladung bzw. Entladung in Phase B stattfindet:

  ▪ einen Schritt (1041B) des Messens des Gesundheitszustands (SOHs), der der Phase B zugeordnet ist;
  ▪ wenn der der Phase A zugeordnete Gesundheitszustand (SOH$_A$) bekannt ist, einen Schritt (1042B1) zum Bestimmen des ganzheitlichen Gesundheitszustands (SOH$_{Tot}$) der Batterie, wobei der ganzheitliche Gesundheitszustand (SOH$_{Tot}$) gleich dem der Phase A zugeordneten Gesundheitszustand (SOH$_A$) plus dem der Phase B zugeordneten Gesundheitszustand (SOHs) ist, der im Schritt (1041B) des Messens des der Phase B zugeordneten Gesundheitszustands (SOH$_B$) gemessen wurde;
  ▪ wenn der der Phase A zugeordnete Gesundheitszustand (SOH$_A$) nicht bekannt ist, einen Schritt (1042B0) des Bestimmens des ganzheitlichen Gesundheitszustands (SOH$_{Tot}$) der Batterie, wobei der ganzheitliche Gesundheitszustand (SOH$_{Tot}$) gleich dem Gesundheitszustand (SOH$_B$) ist, der der Phase B zugeordnet ist, der im Schritt (1041B) des Messens des der Phase B zugeordneten Gesundheitszustands (SOH$_B$) gemessen wird, addiert mit dem der Phase A zugeordneten ursprünglichen Gesundheitszustand (SOH$_A$).

2. Bestimmungsverfahren nach dem vorhergehenden Anspruch, **dadurch gekennzeichnet, dass** der Gesundheitszustand (SOH$_Y$), der mit der Phase Y mit Y = A oder B verbunden ist, mithilfe der folgenden Gleichung gemessen wird:

$$\mathrm{SOH_Y} = 100 \times \frac{\mathrm{Q_{Dch\_}Y(k)}}{\mathrm{Q_{Dch\_}Tot(0)}}$$

wobei SOH$_Y$ der mit der Phase Y verbundene Gesundheitszustand ist, Q$_{Dch\_}$Y(k) die Menge an Ah oder Wh ist, die während einer Ladung bzw. Entladung während der Phase Y in Zyklus k kumuliert wurde, und Q$_{Dch\_}$Tot(0) die Menge an Ah oder Wh ist, die während einer Gesamtladung bzw. Entladung im ersten Zyklus kumuliert wurde.

3. Verfahren (10) zur Bestimmung des Gesundheitszustands (SOH) einer Batterie, der als ganzheitlicher Gesundheitszustand bezeichnet wird, wobei die Spannung an den Anschlüssen der Batterie in Abhängigkeit vom Ladezustand in eine erste Phase, Phase A genannt, und eine zweite Phase, Phase B genannt, unterteilt werden kann, wobei die Phase A und die Phase B unterschiedlich sind und aufeinander folgen, wobei die Phase A einem ersten Gesundheitszustand (SOH$_A$) und die Phase B einem zweiten Gesundheitszustand (SOHs) zugeordnet wird, wobei der ganzheitliche Gesundheitszustand (SOH$_{Tot}$) gleich der Summe des der Phase A zugeordneten Gesundheitszustands (SOH$_A$) und des der Phase B zugeordneten Gesundheitszustands (SOHs) ist und die Veränderung des ganzheitlichen Gesundheitszustands (SOH$_{Tot}$) in zwei aufeinanderfolgende Perioden unterteilt werden kann, einer ersten Periode, in der die Veränderung des ganzheitlichen Gesundheitszustands (SOH$_{Tot}$) hauptsächlich auf die Veränderung des der Phase B zugeordneten Gesundheitszustands (SOH$_B$) zurückzuführen ist, und einer zweiten Periode, in der der der Phase B zugeordnete Gesundheitszustand (SOH$_B$) null wird und der ganzheitliche Gesundheitszustand (SOH$_{Tot}$) dann mit dem der Phase A zugeordneten Gesundheitszustand (SOH$_A$) ineinander übergeht, Verfahren, bei dem der der Phase Y mit Y = A oder B zugeordnete Gesundheitszustand (SOH$_Y$) durch die folgende Gleichung modelliert werden kann:

$$\mathrm{SOH}_Y = \max\left(A_Y x + B_Y, 0\right)$$

wobei $A_X$ und $B_X$ Konstanten sind und x eine Anzahl von äquivalenten Zyklen ist; wobei das Verfahren **dadurch gekennzeichnet ist, dass** es Folgendes umfasst:

- eine erste Phase (IP), die als Initialisierungsphase bezeichnet wird und umfasst:

 - einen Schritt (1051) von mindestens vier Messungen des ganzheitlichen Gesundheitszustands ($SOH_{Tot}$), wobei jede Messung bei einer Ladung bzw. einer vollständigen Entladung durchgeführt wird;
 - einen Schritt (1052) des Bestimmens der Parameter der Modelle, die mit dem Gesundheitszustand ($SOH_A$, $SOH_B$) verbunden sind, der der Phase A und Phase B zugeordnet ist;
 - eine zweite Phase (MP), die als Messphase bezeichnet wird und umfasst:
 - einen Schritt (1053) zum Bestimmen der Anzahl der äquivalenten Zyklen unter Verwendung einer Teilladung bzw. Teilentladung in Phase A oder Phase B;
 - einen Schritt (1054) zum Bestimmen des ganzheitlichen Gesundheitszustands ($SOH_{Tot}$);

wobei der ganzheitliche Gesundheitszustand ($SOH_{Tot}$) aus dem in der Initialisierungsphase (IP) erhaltenen Modell und der in der Messphase (MP) erhaltenen äquivalenten Anzahl von Zyklen bestimmt wird.

4. Bestimmungsverfahren nach dem vorhergehenden Anspruch, **dadurch gekennzeichnet, dass** während der Initialisierungsphase (IP) jede Messung des ganzheitlichen Gesundheitszustands ($SOH_{Tot}$) so durchgeführt wird, dass die Veränderung des ganzheitlichen Gesundheitszustands zwischen dieser Messung und der vorhergehenden Messung größer oder gleich 2 % des Werts dieser Messung ist.

5. Verfahren nach einem der beiden vorhergehenden Ansprüche, **dadurch gekennzeichnet, dass**, wenn das Laden (bzw. Entladen) im Schritt (1053) des Bestimmens der Anzahl der äquivalenten Zyklen während der Phase Y mit Y = A oder B stattfindet, die Anzahl der äquivalenten Zyklen mithilfe der folgenden Formel bestimmt wird:

$$x = \frac{\mathrm{SOH}_Y - B_Y}{A_Y}$$

6. Vorrichtung (DI) zur Bestimmung des Gesundheitszustands einer Batterie mit einem Mittel zur Messung (MM) des in die Batterie ein- und ausgehenden Stroms sowie einem Rechenmittel (MC), das mit dem Messmittel (MM) verbunden und so gestaltet ist, dass es ein Verfahren (10) nach einem der Ansprüche 1 bis 5 durchführt.

7. Computerprogramm mit Anweisungen, die die Vorrichtung (DI) nach Anspruch 6 dazu veranlassen, die Schritte des Verfahrens (10) nach einem der Ansprüche 1 bis 5 auszuführen.

8. Computerlesbarer Datenträger, auf dem das Computerprogramm nach Anspruch 7 gespeichert ist.


**Claims**

1. A method (10) for determining the state of health (SOH) of a battery, referred to as overall state of health, wherein the voltage across the battery as a function of the state of charge can be split into a first phase, referred to as phase A, and a second phase, referred to as phase B, phase A and phase B being distinct and consecutive, phase A being associated with a first state of health ($SOH_A$) and phase B being associated with a second state of health ($SOH_B$), the overall state of health ($SOH_{Tot}$) being equal to the sum of the state of health ($SOH_A$) associated with phase A and the state of health ($SOH_B$) associated with phase B, wherein the evolution of the overall state of health ($SOH_{Tot}$) can be divided into two consecutive periods, a first period during which the variation in the overall state of health ($SOH_{Tot}$) is mainly due to the variation in the state of health ($SOH_B$) associated with phase B and a second period during which the state of health ($SOH_B$) associated with phase B becomes zero and the overall state of health ($SOH_{Tot}$) is then the same as the state of health ($SOH_A$) associated with phase A; the method being **characterised in that** it comprises:

- when the charge, respectively discharge, occurs in phase A:

- a step (1041A) of measuring the state of health ($SOH_A$) associated with phase A;
- if the state of health (SOHs) associated with phase B is zero, a step (1042A0) of determining the overall state of health ($SOH_{Tot}$) of the battery, said overall state of health ($SOH_{Tot}$) being equal to the state of health ($SOH_A$) associated with phase A determined in the step (1041A) of measuring the state of health ($SOH_A$) associated with phase A.
- if the state of health (SOHs) associated with phase B is non-zero, a step (1042A1) of determining the overall state of health ($SOH_{Tot}$) of the battery, said overall state of health ($SOH_{Tot}$) being equal to the state of health ($SOH_A$) associated with phase A determined during the step (1041A) of measuring the state of health ($SOH_A$) associated with phase A added to the state of health ($SOH_B$) associated with phase B determined during a previous measurement;

- and/or when the charge, respectively discharge, occurs in phase B:

- a step (1041B) of measuring the state of health ($SOH_B$) associated with phase B;
- if the state of health ($SOH_A$) associated with phase A is known, a step (1042B1) of determining the overall state of health ($SOH_{Tot}$) of the battery, said overall state of health ($SOH_{Tot}$) being equal to the state of health ($SOH_A$) associated with phase A added to the state of health ($SOH_B$) associated with phase B measured in the step (1041B) of measuring the state of health ($SOH_B$) associated with phase B;
- if the state of health ($SOH_A$) associated with phase A is not known, a step (1042B0) of determining the overall state of health ($SOH_{Tot}$) of the battery, said overall state of health ($SOH_{Tot}$) being equal to the state of health ($SOH_B$) associated with phase B measured in the step (1041B) of measuring the state of health (SOHs) associated with phase B added to the state of health ($SOH_A$) associated with the initial phase A.

2. The determining method according to the preceding claim, **characterised in that** the state of health ($SOH_Y$) associated with phase Y with Y = A or B is measured using the following equation:

$$SOH_Y = 100 \times \frac{Q_{Dch\_}Y(k)}{Q_{Dch\_}Tot(0)}$$

where $SOH_Y$ is the state of health associated with phase Y, $Q_{Dch\_}Y(k)$ is the amount of Ah or Wh accumulated during a charge, respectively discharge, during phase Y at cycle k and $\bar{Q}_{Deh\_}Tot(0)$ is the amount of Ah or Wh accumulated during a total charge, respectively discharge, at the first cycle.

3. The method (10) for determining the state of health (SOH) of a battery, referred to as overall state of health, the voltage across the battery as a function of the state of charge can be split into a first phase, referred to as phase A, and a second phase, referred to as phase B, phase A and phase B being distinct and consecutive, phase A being associated with a first state of health ($SOH_A$) and phase B being associated with a second state of health ($SOH_B$), the overall state of health ($SOH_{Tot}$) being equal to the sum of the state of health ($SOH_A$) associated with phase A and the state of health ($SOH_B$) associated with phase B, wherein the evolution of the overall state of health ($SOH_{Tot}$) can be divided into two consecutive periods, a first period during which the variation in the overall state of health ($SOH_{Tot}$) is mainly due to the variation in the state of health ($SOH_B$) associated with phase B and a second period during which the state of health ($SOH_B$) associated with phase B becomes zero and the overall state of health ($SOH_{Tot}$) is then the same as the state of health ($SOH_A$) associated with phase A, method wherein the state of health ($SOH_Y$) associated with phase Y with Y = A or B can be modelled by the following equation:

$$SOH_Y = \max(A_Y x + B_Y, 0)$$

where $A_X$ and $B_X$ are constants and x is a number of equivalent cycles; the method being **characterised in that** it comprises

- a first phase (IP), referred to as the initialisation phase and comprising:

- a step (1051) of performing at least four measurements of the overall state of health ($SOH_{Tot}$), each measurement being performed on a full charge, respectively discharge;
- a step (1052) of determining the parameters of the models associated with the state of health ($SOH_A$, SOHs) associated with phase A and phase B;

- a second phase (MP), referred to as the measurement phase and comprising:
- a step (1053) of determining the number of equivalent cycles using a partial charge, respectively discharge, in phase A or phase B;
- a step (1054) of determining the overall state of health ($SOH_{Tot}$);

the overall state of health ($SOH_{Tot}$) being determined from the model obtained during the initialisation phase (IP) and the number of equivalent cycles obtained during the measurement phase (MP).

4. The determining method according to the preceding claim, **characterised in that**, during the initialisation phase (IP), each measurement of the overall state of health ($SOH_{Tot}$) is performed so that the variation in the overall state of health between said measurement and the previous measurement is greater than or equal to 2% of the value of said measurement.

5. The method according to one of the two preceding claims **characterised in that**, when the charge (respectively, discharge) during the step (1053) of determining the number of equivalent cycles occurs during phase Y with Y = A or B, the number of equivalent cycles is determined using the following formula:

$$x = \frac{SOH_Y - B_Y}{A_Y}$$

6. A device (DI) for determining the state of health of a battery comprising a measurement means (MM) for measuring the current entering and leaving the battery as well as a calculator means (MC) connected to said measurement means (MM) and configured to implement a method (10) according to any of claims 1 to 5.

7. A computer program comprising instructions which cause the device (DI) according to claim 6 to perform the steps of the method (10) according to any of claims 1 to 5.

8. A computer-readable medium, on which the computer program according to claim 7 is recorded.

FIG. 1A

FIG. 1B

FIG. 2

FIG. 3

FIG. 4

10

FIG. 5

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015049300 A1
- WO 2017050944 A
- WO 2015086753 A
- FR 3051981 A1